Europäisches Patentamt

European Patent Office

Office européen des brevets

(11) Veröffentlichungsnummer: **0 142 076
B1**

# EUROPÄISCHE PATENTSCHRIFT

(45) Veröffentlichungstag der Patentschrift:
**22.06.88**

(51) Int. Cl.⁴: **H 05 K 13/04**

(21) Anmeldenummer: **84112770.7**

(22) Anmeldetag: **23.10.84**

(54) **Vorrichtung zum Bestücken von Leiterplatten.**

(30) Priorität: **07.11.83 DE 3340147**

(43) Veröffentlichungstag der Anmeldung:
**22.05.85 Patentblatt 85/21**

(45) Bekanntmachung des Hinweises auf die Patenterteilung:
**22.06.88 Patentblatt 88/25**

(84) Benannte Vertragsstaaten:
**DE FR GB IT**

(56) Entgegenhaltungen:
**FR - A - 2 386 962
FR - A - 2 405 108
FR - A - 2 476 964
GB - A - 802 660
GB - A - 1 585 705
US - A - 2 758 303
US - A - 2 808 587
US - A - 2 827 634
US - A - 4 218 817
US - A - 4 288 914
US - A - 4 309 808**
(73) Patentinhaber: **Siemens Aktiengesellschaft Berlin und München, Wittelsbacherplatz 2, D-8000 München 2 (DE)**

(72) Erfinder: **Richter, Martin, Schulstrasse 20, D-8525 Marloffstein (DE)**
Erfinder: **Schweiger, Josef, Elsterweg 3, D-8521 Möhrendorf (DE)**

EP 0 142 076 B1

ACTORUM AG

## Beschreibung

Die Erfindung bezieht sich auf eine Vorrichtung zum Bestücken von Leiterplatten mit elektronischen Bauelementen mit mehr als zwei Anschlüssen gemäss dem Oberbegriff des Patenanspruches 1.

Die Bestückung von Leiterplatten mit elektronischen Bauelementen kann mit Bestückautomaten weitgehend vollautomatisch erfolgen. Bedrahtete Bauelemente, wie beispielsweise Widerstände, Kondensatoren oder Dioden, werden mit ihren Anschlussfüssen durch die Löcher der Leiterplatten gesteckt, die Anschlussdrähte umgebogen und abgeschnitten.

Aus der US-A-4 218 817 ist eine Überwachungseinrichtung für die Bestückung von bedrahteten Bauelementen bekannt, bei welcher den beweglichen Schneidmessern je zwei Dehnungsmessstreifen zugeordnet sind, die sich auf gegenüberliegenden Seiten der Schwenkkörper, in den durch einen Hohlraum in zwei Wandbereiche aufgeteilt sind, von denen der eine auf Zug und der andere auf Druck beansprucht wird, befinden. Mittels einer Wheatstone'schen Brückenschaltung wird die Summe der elektrischen Signale erfasst und ausgewertet.

Weiterhin ist aus der US-A-4 288 914 eine solche Überwachungseinrichtung bekannt, bei welcher während des Biege- und Schneidvorganges der elektrische Kontaktschluss zwischen Schneidmesser, Anschlussfuss und Amboss erfasst wird.

Insbesondere beim Einsetzen von 4- bis 40poligen IC-Bauelementen mit gereihten Anschlussfahnen (DIP-Bauelemente) durch Bestückautomaten treten häufig Durchsteckfehler auf. Dabei stehen die als Metallfahnen ausgebildeten Anschlussfüsse der Bauelemente vereinzelt ausserhalb ihres Kontaktier-Lochbereiches und knicken beim Einsetzen um. Als unerwünschte Folge ergeben sich dadurch fehlerhafte Kontaktierungen. Bisher müssen daher die mit DIP-Bauelementen bestückten Flachbaugruppen nach dem Einsetzvorgang einer visuellen Kontrolle unterzogen werden, wobei insbesondere die Paarigkeit der durchgesteckten Anschlussfüsse pro Bauelement zu prüfen ist. Die bekannten Überwachungsvorrichtungen sind dafür nicht geeignet.

Zur Vereinfachung der oben beschriebenen Sichtkontrolle werden in der Praxis die Anschlussfüsse mittels Kohlepapier und Gummi-Andruckwalze auf neutralem Papier abgebildet, wodurch die Kontrolle einfacher wird. Es wurde auch vorgeschlagen, bei einer Vorrichtung zum Bestücken von Leiterplatten den zugehörigen Amboss mit einer optischen Überwachungseinrichtung für die auf der den Bauelementen gegenüberliegenden Seite der Leiterplatte aus den Anschlussöffnungen herausragenden Anschlussfussenden zu versehen (deutsche Patentanmeldung P 33 18 110.1).

Der Erfindung liegt daher die Aufgabe zugrunde, eine Vorrichtung der im Oberbegriff des Patentanspruches 1 genannten Art mit einfachen technischen Mitteln dahingehend zu verbessern, dass eine automatische Überwachung des Bestückvorganges von mehrpoligen Baulementen mit gereihten Anschlussfahnen erreichbar wird.

Die Aufgabe ist erfindungsgemäss durch die Gesamtheit der Merkmale des Patentanspruches 1 gelöst Dabei beinhaltet das Kennzeichen die gegenüber der US-A-4 218 817 neuen Merkmale. Vorteilhafte Weiterbildungen sind in den Unteransprüchen angegeben.

Der Unterbau der Bestückstation eines Bestückautomaten besteht in bekannter Weise aus zwei Schneidwerkzeugen, mit der die Anschlussfüsse eines Bauelementes an der linken und rechten Seite zur gleichen Zeit nach aussen gebogen und auf geeignete Länge abgeschnitten werden. Dabei ist jedes Schneidwerkzeug aus einem feststehenden und einem beweglichen Schneidmesser aufgebaut. Vorteilhafterweise sind die durch die erfindungsgemässe Schlitzung unterteilten Messer die Obermesser der Schneidwerkzeuge, die leicht zugänglich sind.

Die Erfindung nutzt die beim Schnitt wirkenden Druck- und Biegekräfte speziell auf die feststehenden Schneidenbereiche aus. Über die den Schneidenbereichen unmittelbar zugeordneten Dehnungsmessstreifen wird von jedem Anschlussfuss ein elektrisches Signal erzeugt, das auf einem Sichtgerät darstellbar und entsprechend auswertbar ist.

Der Erfindung lag die Erkenntnis zugrunde, dass eine Schneide ohne Verlust ihrer Schneidwirkung an den einzelnen Anschlussfüssen durch Schlitzung in entsprechende Einzelschneiden unterteilbar ist, wobei die so entstehenden Schneidzungen jeweils mit einem Dehnungsmessstreifen appliziert werden können. Zwecks Auswertung in der Auswerteeinheit werden die Signale in vorteilhafter Weise über Anpassverstärker mit einem Mikroprozessor verbunden, in dem insbesondere eine Paarigkeitskontrolle durchführbar ist.

Bei der Vorrichtung gemäss der Erfindung ist vorteilhaft, dass eine sofortige Durchsteckfehlererkennung beim Einsetzen und Schneiden eines IC-Bauelementes ermöglicht wird. Dabei können nunmehr auch IC-Bauelemente mit kurzen Anschlussfahnen verwendet werden. Aufgrund der unmittelbaren visuellen Kontrolle an der Auswerteeinheit können fehlerhafte Bauelemente markiert und registriert werden, wobei der Bestückautomat weiterlaufen kann. Während des Arbeitsflusses des Bestückungsautomaten entfällt das Suchen nach fehlerhaften Bauelementen. Die mit Durchsteckfehlern behafteten Bauelemente sind markiert bzw. registriert, so dass die Leiterplatten einer Reparatur zugeführt werden können.

Mit der erfindungsgemässen Vorrichtung können Aussagen über paarig umgeknickte Anschlüsse erhalten werden, wozu deren Anzahl vor und nach dem Bestückungsvorgang eines Bauelementes verglichen werden muss. Es ist möglich, an der erfindungsgemässen Vorrichtung zusätzliche Mittel zur automatischen Erfassung der Anzahl der Anschlussfüsse vorzusehen und einen unmittelbaren Vergleich zwischen der Zahl der Anschlüsse vor dem Einstecken und nach dem Schneiden durchzuführen oder die Anzahl der geschnittenen Anschlüsse jeweils mit der gemäss Programm vorhandenen zu vergleichen. In diesem Fall ist der Programmablauf in die Überwachung des Automaten einzubeziehen.

Weitere Einzelheiten und Vorteile der Erfindung ergeben sich aus der nachfolgenden Figurenbeschreibung eines Ausführungsbeispiels anhand der Zeichnung in Verbindung mit den Patentansprüchen.

Es zeigen

FIG 1 eine perspektivische Darstellung und

FIG 2 eine Explosionsdarstellung des Werkzeuges eines bekannten Bestückungsautomaten,

FIG 3 und 4 die Seitenansicht und Draufsicht eines Schneidmessers für einen erfindungsgemäss ausgebildeten Bestückungsautomaten und

FIG 5 die Verstärkerschaltung für einen einzigen Dehnungsmessstreifen.

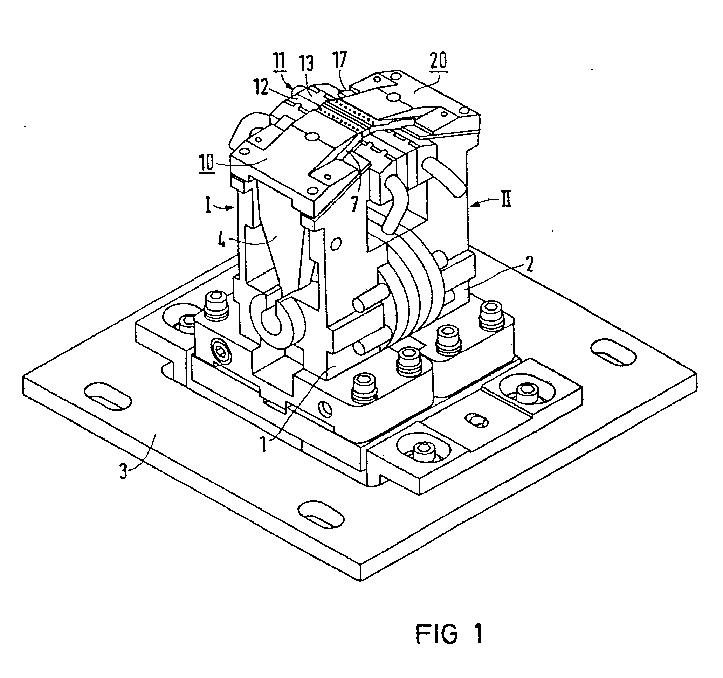

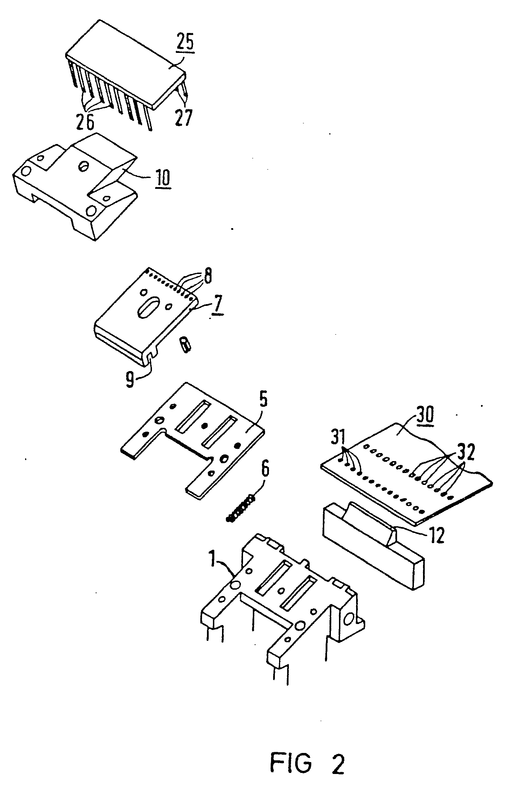

In den Figuren sind identische Teile durchweg mit den gleichen Bezugszeichen versehen. Insbesondere in FIG 1 und FIG 2 sind nur die zum Verständnis der Erfindung notwendigen Einzelheiten erläutert.

FIG 1 zeigt eine handelsübliche Bestückungsvorrichtung, wie sie beispielsweise von der Firma Universal Instruments Corp. geliefert wird. Sie besteht im wesentlichen aus zwei spiegelbildlich zueinander stehenden Werkzeugeinheiten I und II, die nachfolgend im einzelnen erläutert werden:

Es bedeuten 1 und 2 jeweils Haltebacken, die auf einem Gerüst 3 verschiebbar geführt sind. Wie in einzelnen aus der Explosionsdarstellung nach FIG 2 hervorgeht, sind auf dem Haltebacken 1, über eine Zwischenplatte 5 ein verschiebbares Untermesser 7 und ein feststehendes Obermesser 10 gehalten. In der Zwischenplatte 5 sind Federn 6 zur Rückstellung des verschiebbaren Messers 7 angeordnet. Das Messer 7 weist im einzelnen Durchführungen 8 für die Füsse von Bauelementen auf. Betätigt wird das Schneidmesser 7 durch einen Kipphebel 4, der in FIG 1 ersichtlich ist, und der in eine Nut 9 des Schneidmessers 7 eingreift.

In der Schneideinheit II sind die den Teilen 4 bis 10 entsprechenden Einzelheiten mit 14 bis 20 bezeichnet, wobei in FIG 1 im wesentlichen nur das Untermesser 17 und das Obermesser 20 erkennbar wird. Zwischen den beiden Schneidwerkzeugen ist ein Amboss 11 angeordnet, der aus Einheiten 12 und 13 besteht und Ausnehmungen sowie Abführungen für Schneidabfälle und dergleichen aufweist.

In FIG 2 ist weiterhin ein vielpoliges IC-Bauelement 25 angedeutet, das mit seinen zwei Reihen von Anschlussfüssen 26 und 27 in die Reihe von Durchtrittsöffnungen 31 bzw. 32 einer Leiterplatte 30 eingesteckt werden soll. Dem Steckvorgang folgt bei der bekannten Vorrichtung ein automatisches Abbiegen und Abschneiden der Anschlussfüsse.

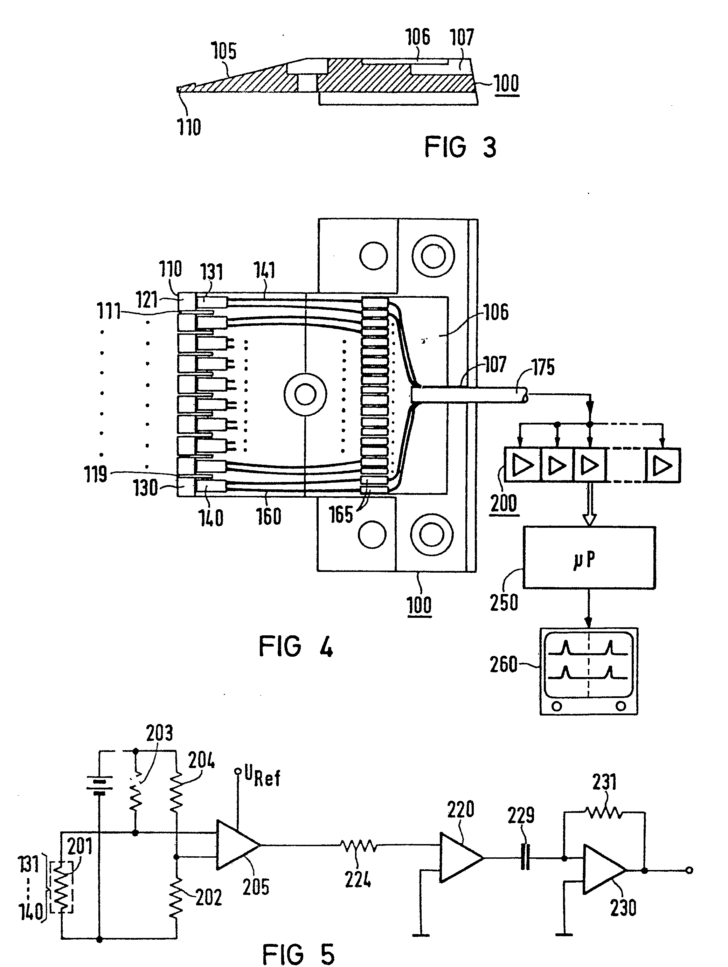

In FIG 3 und FIG 4 ist der Grundkörper des Oberschneidmessers 10 bzw. 20 nach FIG 1 bzw. FIG 2 mit 100 bezeichnet. Er weist die gleiche Raumform auf, wie dort gezeigt. Von der Oberseite her sind in den Formkörper 100 Aussparungen 105, 106 und 107 eingefräst.

Der Formkörper 100 des Oberschneidmessers 10 bzw. 20 nach FIG 1 hat frontseitig in bekannter Weise eine Schneidkante 110. Die Schneidkante 110 ist nun mit parallel zur Seitenlinie liegenden Schlitzen 111 bis 119 versehen. Diese Schlitze sind 0,35 mm breit und haben eine Tiefe in den Formkörper hinein von etwa 5 mm. Durch die Schlitze 111 bis 119 werden im Bereich der Schneidkante einzelne Zungen 121 bis 130 gebildet, welche jeweils separate Teilschneiden definieren. Auf jeder Teilschneide 121 bis 130 ist ein Dehnungsmessstreifen 131 bis 140 (DMS) im Bereich der Aussparung angebracht. Von den einzelnen DMS 131 bis 140 führen Signalleitungen 141 bis 160 im Bereich der Ausnehmung 106 zu einer Signalleiste 165 mit zwanzig Kontakten und von dort weitere Leitungen über ein gemeinsames Kabel 170 zu einer Signalverarbeitungsschaltung. Diese Signalverarbeitungsschaltung besteht aus je einem Anpassverstärker mit Brückenschaltung für einen der DMS 131 bis 140, welche pauschal mit 200 bezeichnet ist und nachfolgend im einzelnen noch beschrieben wird, einen Mikroprozessor-System 250 und einem nachgeschalteten Sichtgerät 260.

Beim Bestücken von Leiterplatten mit Bauelementen mit Abbiegen und Abschneiden der Anschlussfahnen in geeigneter Länge werden auf die Schneidkante Druck- und Biegespannungen ausgeübt. Durch die erfindungsgemässe Ausbildung der Schneidkante 110 in einzelne Schneidzungen 121 bis 130 lässt sich nun die Kraftwirkung jedes einzelnen Anschlussfusses erfassen und das diesbezügliche Signal separat verarbeiten. Dafür müssen aber die Signale zunächst in geeigneter Weise aufbereitet und vorverstärkt werden.

In FIG 5 ist gezeigt, dass die Widerstandsänderung eines jeden DMS durch eine Brückenschaltung mit den angedeuteten Widerständen 201 bis 204 erfasst wird. Die Messspannung wird auf einen Brückenverstärker 205 gegeben, der in bekannter Weise mit Kapazitäten und ohmschen Widerständen beschaltet ist. Eine Referenzspannung ist von einer Normspannungsquelle über Widerstände justierbar. Auf Schaltungseinzelheiten wird im einzelnen nicht Bezug genommen.

Das Ausgangssignal des Brückenverstärkers 205 wird auf einen Operationsverstärker 220 gegeben, der in bekannter Weise mit nicht dargestellten ohmschen Wiederständen und Kapazitäten beschaltet ist. Zur Vermeidung jeglicher Drifteinflüsse der DMS-Brücke ist eine kapazitive Kopplung vorgesehen. Dafür ist dem Ausgang ein Kondensator 229 nachgeschaltet, von wo das Signal auf einen weiteren Operationsverstärker 230 gelangt. Der Operationsverstärker 230 ist über einen Widerstand 231 rückgekoppelt und als Impulsformer und Treiber geschaltet. Statt der einzelnen Messkanäle mit je einem Messverstärker kann auch ein einziger, gemeinsamer Verstärker vorhanden sein, an den die einzelnen Dehnungsmessstreifen zur Signalerfassung zyklisch nacheinander angeschaltet werden.

Vorliegende Schaltung liefert neben der geeigneten Verstärkung ein Ausgangssignal unabhängig von der Drift der einzelnen Bauelemente. Im Ergebnis liegt am Ausgang ein Binärsignal als logische Null oder Eins vor. Das Nullsignal bedeutet, dass ein Schneidvorgang an einen Anschlussfuss nicht stattgefunden hat, dass also ein Kontaktierfehler vorliegt. Die Eins bedeutet dagegen, dass der Anschlussfuss korrekt durchgesteckt, abgebogen und abgeschnitten ist. Ein entsprechendes Rechtecksignal lässt sich nach Verarbeitung in der Mikroprozessoreinheit 250 auf dem Sichtschirm eines Anzeigegerätes 260 darstellen.

Durch die Mikroprozessoreinheit 250 lässt sich unmittelbar eine Paarigkeitskontrolle bei der mit Bauelementen bestückten Leiterplatte durchführen. Dabei werden lediglich die Signale von sich gegenüberliegenden Anschlussfüssen verglichen.

Es ist in der Praxis nicht auszuschliessen, dass zwei gegenüberliegende Anschlussfüsse eines IC-Bauelementes beim Bestückvorgang umknikken und Fehlkontakte bewirken. Um gleichzeitig auch paarig umgeknickte Anschlüsse erkennen zu können, wäre bei der Vorrichtung gemäss FIG 1 und FIG 2 eine Einheit zur Erfassung der Anzahl der Anschlussfüsse vor dem Einstecken erforderlich. Es ist aber auch möglich, eine Verknüpfung der Überwachung einer Leiterplatte mit dem Bestückprogramm dieser Leiterplatte vorzusehen. Für die Auswertung in der Mikroprozessoreinheit 250 kann dabei in geeigneter Weise die Software des Maschinenprogramms einbezogen werden.

**Patentansprüche**

1. Vorrichtung zum Bestücken von Leiterplatten mit elektronischen Bauelementen (25) mit mehr als zwei Anschlüssen (26, 27), deren gereihten Anschlussfahnen in Öffnungen (31, 32) der auf einem Amboss (12) liegenden Leiterplatte (30) einfügbar sind zwecks Abbiegen und Abschneiden der Anschlussfahnen (26, 27) mittels geeigneter Schneidwerkzeuge (1 bis 20) aus je einem feststehenden (10, 20) und einem beweglichen Schneidmesser (7, 17), wobei den Schneidwerkzeugen (10, 20) als Dehnungsmessstreifen ausgebildete Sensorelemente (131 bis 140) zwecks Erfassung der Biege- und Schnittkräfte im Schneidmesser (7, 10, 17, 20) zugeordnet sind, dadurch gekennzeichnet, dass die feststehenden Schneidmesser (10, 20) schneidkantenseitig durch parallele Schlitze (111 bis 119) in einzelne Schneidzungen (121 bis 130) unterteilt sind, von denen jede einen dem Schneidbereich unmittelbar zugeordneten, einzigen Dehnungsmessstreifen (131 bis 140) trägt, dessen Signale in einer Auswerteeinheit (200, 250, 260) erfassbar und als Kontrollsignal für das erfolgte Abbiegen und Abschneiden einer einzelnen Anschlussfahne anzeigbar ist.

2. Vorrichtung nach Anspruch 1, dadurch gekennzeichnet, dass das durch Schlitzung unterteilte Schneidmesser das Oberschneidmesser (10, 20) des Schneidwerkzeuges (1–20) ist.

3. Vorrichtung nach einem der vorhergehenden Ansprüche, dadurch gekennzeichnet, dass der Körper (100) der Schneidmesser (10, 20) im Bereich der Oberseite Aussparungen aufweist, in die die Dehnungsmessstreifen (131–140) einschliesslich der Zuleitungen (141–160) einfügbar sind.

4. Vorrichtung nach Anspruch 3, dadurch gekennzeichnet, dass die Signalleitungen (141–160) von den Dehnungsmessstreifen (131–140) innerhalb der Aussparung (105–107) zu einer Anschlussleiste (165) und von dort in einem gemeinsamen Kabel (175) geführt werden.

5. Vorrichtung nach Anspruch 3, dadurch gekennzeichnet, dass die Aussparungen (105–107) mit einem Deckel formschlüssig abdeckbar sind.

6. Vorrichtung nach einem der vorhergehenden Ansprüche, dadurch gekennzeichnet, dass jedem einzelnen Dehnungsmessstreifen (131–140) ein eigener Messkanal (200) mit Messwertverstärker (201–232) zugeordnet ist.

7. Vorrichtung nach einem der vorhergehenden Ansprüche, dadurch gekennzeichnet, dass nur ein gemeinsamer Verstärker vorhanden ist, an den die einzelnen Dehnungsmessstreifen (131–140) zyklisch nacheinander angeschaltet werden.

8. Vorrichtung nach einem der vorhergehenden Ansprüche, dadurch gekennzeichnet, dass zur Signalauswertung ein Mikroprozessor-System (250) mit angeschlossenem Display (260) vorhanden ist.

9. Vorrichtung nach einem der vorhergehenden Ansprüche, dadurch gekennzeichnet, dass die Signale der Schneidzungen (121–151) zur Paarigkeitskontrolle verknüpfbar sind.

10. Vorrichtung nach einem der vorhergehenden Ansprüche, dadurch gekennzeichnet, dass zur Erkennung paarig ungeknickter Anschlüsse (26, 27) eine Erfassung der Anschlusszahl vor dem Einstecken der Bauelemente (25) erfolgt.

11. Vorrichtung nach einem der vorhergehenden Ansprüche, dadurch gekennzeichnet, dass zur Erkennung paarig ungeknickter Anschlüsse (26, 27) eines Bauelementes (25) eine Verknüpfung von Bestück- und Überwachungsprogramm erfolgt.

**Revendications**

1. Dispositif pour équiper des plaquettes à circuits imprimés avec des composants électroniques (25) comportant plus de deux bornes (26, 27), dont on peut insérer les languettes de raccordement, disposées en rangée, dans des ouvertures (31, 32) de la plaquette à circuits imprimés (30) située sur une enclume (12), afin de réaliser le pliage et le découpage des languettes de raccordement (26, 27) au moyen d'outils de coupe appropriés (1 à 20) constitués chacun par un couteau fixe (10, 20) et un couteau mobile (7, 17), des éléments de détection (131 à 140) réalisés sous la forme de jauges extensométriques étant associées aux outils de coupe (10, 20) afin de détecter les forces de pliage et de découpage dans le couteau (7, 10, 17, 20), caractérisé par le fait que les couteaux fixes (10, 20) sont subdivisés, du côté de l'arête de coupe, par des fentes parallèles (11 à 119), en languettes de coupe individuelles (121 à 130), dont chacune porte une seule jauge extensométrique (131 à 140), associée directement à la zone de coupe et dont les signaux peuvent être détectés dans une unité d'exploitation (200, 250, 260) et peuvent être affichés en tant que signal de contrôle de l'exécution du pliage et du découpage d'une languette individuelle de raccordement.

2. Dispositif suivant la revendication 1, caractérisé par le fait que le couteau subdivisé par les fentes est le couteau supérieur (10, 20) de l'outil de coupe (1–20).

3. Dispositif suivant l'une des revendications précédentes, caractérisé par le fait que le corps (100) des couteaux (10, 20) comporte, au niveau de son côté supérieur, des évidements dans lesquels les jauges extensométriques (131–140) peuvent être insérées, y compris les conducteurs d'alimentation (141–160).

4. Dispositif suivant la revendication 3, caractérisé par le fait que les conducteurs de transmission de signaux (141–160) s'étendent depuis les jauges extensométriques (131–140), à l'intérieur de l'évidement (105–107) pour aboutir à une barrette de connexions (165) et s'étendent, à partir de là, dans un câble commun (175).

5. Dispositif suivant la revendication 3, caractérisé par le fait que les évidements (105–107) sont recouverts, selon une liaison par formes complémentaires, par un couvercle.

6. Dispositif suivant l'une des revendications précédentes, caractérisé par le fait qu'à chaque jauge extensométrique individuelle (131–140) est associé un canal propre de mesure (200) comportant un amplificateur de mesure (201, 232).

7. Dispositif suivant l'une des revendications précédentes, caractérisé par le fait qu'il est prévu un seul amplificateur commun, auquel sont raccordées successivement, de façon cyclique, les différentes jauges extensométriques (131–140).

8. Dispositif suivant l'une des revendications précédentes, caractérisé par le fait que pour l'exploitation des signaux, il est prévu un système à microprocesseur (250) auqel est raccordé un dispositif d'affichage (260).

9. Dispositif suivant l'une des revendications précédentes, caractérisé par le fait que les signaux des languettes de coupe (121–151) peuvent être combinés pour réaliser le contrôle de jumelage.

10. Dispositif suivant l'une des revendications précédentes, caractérisé par le fait que pour l'identification de bornes (26, 27) non repliées par couples, on réalise la détection du nombre des bornes avant l'enfichage des composants (25).

11. Dispositif suivant l'une des revendications précédentes, caractérisé par le fait que pour l'identification de bornes (26, 27), non repliées par couples, d'une composant (25), on réalise une combinaison d'un programme d'équipement et d'un programme de contrôle.

**Claims**

1. Device for mounting onto printed circuit boards electronic components (25) with more than two terminals (26, 27) whose terminal lugs arranged in series can be inserted into openings (31, 32) of a printed circuit board (30) which lies on an anvil (12) for the purpose of bending and cutting off the terminal lugs (26, 27) by means of suitable cutting tools (1–20), each consisting of one fixed (10, 20) and one movable (7, 17) cutting blade, where sensor elements (131–140) constructed as strain gauges are assigned to the cutting tools (10, 20) for the purpose of measuring the bending and cutting power in the cutting blade (7, 10, 17, 20), characterised in that the fixed cutting blades (10, 20) are subdivided on the cutting edge side by parallel slits (111–119) into individual cutters (121–130) each of which carries a single strain gauge (131–140) which has been assigned directly to the cutting region, whose signals can be recorded in an analyzing unit (200, 250, 260) and can be displayed as a monitoring signal for the successful bending and cutting of an individual terminal lug.

2. Device according to claim 1, characterised in that the cutting blade which is subdivided by slitting is the upper cutting blade (10, 20) of the cutting tool (1–20).

3. Device according to one of the preceding claims, characterised in that the body (100) of the cutting blades (10, 20) has recesses in the region of the upper side into which the strain gauges (131–140) including the lead wires (141–160) can be inserted.

4. Device according to claim 3, characterised in that the signal wires (141–160) are led from the strain gauges (131–140) within the recess (105–107) to a terminal block (165) and from there are led in a common cable (175).

5. Device according to claim 3, characterised in that the recesses (105–107) are able to be covered with a lid in a shape-sealed fashion.

6. Device according to one of the preceding claims, characterised in that each individual strain gauge (131–140) has its own signal channel (200) with measuring amplifier (201–232) assigned to it.

7. Device according to one of the preceding claims, characterised in that only one amplifier is available, to which the individual strain gauges (131–140) are cyclically connected one after the other.

8. Device according to one of the preceding claims, characterised in that for the evaluation of the signals a micro-processor system (250) with a connected display (260) is available.

9. Device according to one of the preceding claims, characterised in that the signals of the cutters (121–151) can be linked for monitoring pairing.

10. Device according to one of the preceding claims, characterised in that for recognising paired unbent terminals (26, 27) the number of terminals is recorded before inserting the components (25).

11. Device according to one of the preceding claims, characterised in that for recognising the paired unbent terminals (26, 27) of a component (25), a link between the mounting and monitoring program is made.

FIG 1

FIG 2

FIG 3

FIG 4

FIG 5